# EUROPÄISCHE PATENTANMELDUNG

(11) **EP 2 479 522 A2**
(43) Veröffentlichungstag der Anmeldung: **25.07.2012**
(21) Anmeldenummer: 12150913.7
(22) Anmeldetag: 12.01.2012
(51) Int. Cl.: F25D 23/06

(54) **Kältegerät und Herstellungsverfahren dafür**

(30) Priorität: 21.01.2011 DE 102011002949
(71) Anmelder: BSH Bosch und Siemens Hausgeräte GmbH, 81739 München (DE)
(72) Erfinder: Fauser, Christoph, 89275 Elchingen (DE); Grittner, Gunter, 89233 Neu-Ulm (DE); Moch, Holger, 89537 Giengen (DE); Roth, Hans-Markus, 89537 Giengen (DE)

(57) **Zusammenfassung**

Ein Verdampfer für ein Kältegerät, insbesondere ein Haushaltskältegerät, wird erhalten durch:
- Abscheiden einer Metallschicht (7) auf einer Oberfläche (2; 13, 14, 15) eines Innenbehälters (1; 1') aus einem Plasma bei Atmosphärendruck, und
- Anbringen eines Kältemittelrohrs (8) in wärmeleitendem Kontakt mit der Metallschicht (7).

## Beschreibung

Die vorliegende Erfindung betrifft ein Kältegerät, insbesondere ein Haushaltskältegerät, und ein Herstellungsverfahren, insbesondere für den Verdampfer in einem solchen Kältegerät.

Herkömmlicherweise umfasst der Verdampfer eines Coldwall-Kältegeräts eine Metallplatte oder Platine, an der auf einer Seite ein Kältemittelrohr befestigt ist und die mit ihrer anderen Seite an einem Innenbehälter des Kältegeräts verklebt ist. Zum Verkleben des Verdampfers wird üblicherweise zweiseitiges Klebeband verwendet. Das Klebeband behindert den Wärmeaustausch zwischen Innenbehälter und Verdampfer, aber noch störender für den Wärmeaustausch als das Klebeband selber sind eventuelle Klebefehler in Form von Lücken der Klebebandschicht oder von zwischen dem Klebeband und dem Innenbehälter oder der Platine eingeschlossenen Luftblasen. Zwischen Innenbehälter und Verdampfer eindringende Feuchtigkeit kann zur Ablösung des Klebebands und dadurch ebenfalls zu einer Beeinträchtigung des Wärmeaustauschs führen.

Aus DE10223865A1 ist ein Verfahren zur Plasmabeschichtung von Werkstücken unter Atmosphärendruck bekannt, das zum Aufbringen von das Entformen erleichternden metallhaltigen Beschichtungen auf den Oberflächen von Formwerkzeugen oder von Barriereschichten auf Kunststoffen empfohlen wird.

Aufgabe der vorliegenden Erfindung ist, ein Kältegerät bzw. ein Fertigungsverfahren zu schaffen, die mit geringem Aufwand eine ausgezeichnete thermische und mechanische Anbindung eines Verdampfers an einen Innenbehälter des Kältegeräts gewährleisten.

Unter einem Kältegerät wird insbesondere ein Haushaltskältegerät verstanden, also ein Kältegerät das zur Haushaltsführung in Haushalten oder eventuell auch im Gastronomiebereich eingesetzt wird, und insbesondere dazu dient Lebensmittel und/oder Getränke in haushaltsüblichen Mengen bei bestimmten Temperaturen zu lagern, wie beispielsweise ein Kühlschrank, ein Gefrierschrank, eine Kühlgefrierkombination, eine Gefriertruhe oder ein Weinlagerschrank.

Die Aufgabe wird gelöst, indem auf einer Oberfläche des Innenbehälters aus einem Plasma bei Atmosphärendruck eine Metallschicht abgeschieden und auf der so erhaltenen Metallschicht ein Kältemittelrohr in wärmeleitendem Kontakt angebracht wird. Da die Metallschicht erst auf der Oberfläche entsteht, indem Metallpartikel aus dem Plasmastrom auf die Oberfläche aufprallen und an ihr haften, ist ein Einschluss von Luftblasen zwischen ihr und der Oberfläche ausgeschlossen.

Das Plasma wird vorzugsweise in einem sauerstofffreien Trägergas erzeugt, um eine Oxidation des Metalls während des Abscheidens zu verhindern. Dies ist insbesondere dann zweckmäßig, wenn das abgeschiedene Metall Aluminium ist.

Wenn die Temperatur des Trägergases beim Auftreffen auf die Oberfläche auf unter 200°C begrenzt wird, ist das Aufbringen der Metallschicht auch auf eine gegen hohe Temperaturen empfindliche Kunststoffoberfläche und insbesondere auf thermoplastischen Kunststoff möglich.

Die aus dem Plasma abgeschiedene Metallschicht haftet an der Oberfläche des Innenbehälters, ohne dass zwischen ihr und dem Innenbehälter eine haftvermittelnde Schicht erforderlich wäre. Dadurch ist ein ideal enger thermischer Kontakt zwischen der Metallschicht und dem Innenbehälter garantiert.

Während die Platine eines herkömmlichen Wärmetauschers für ein Haushaltskältegerät üblicherweise eine Stärke von mehreren 100 µm benötigt, um ohne die Gefahr einer Beschädigung handhabbar und auf dem Innenbehälter verklebbar zu sein, genügt, um eine gleichmäßige Temperaturverteilung auf der Oberfläche des Innenbehälters zu erzielen, eine Metallschicht von nicht mehr als 100 µm Stärke. In dem die Metallschicht mit dieser geringen Stärke abgeschieden wird, kann der Materialeinsatz reduziert werden, und auch die zum Erzeugen der Metallschicht benötigte Zeit kann in vertretbaren Grenzen gehalten werden.

Eine gewisse Mindeststärke der Metallschicht ist erforderlich, damit diese ihre Aufgabe erfüllen kann, für eine gleichmäßige Temperaturverteilung zu sorgen. Die Dicke der Metallschicht sollte daher wenigstens 10 µm betragen.

Das Metallrohr ist auf der Metallschicht vorzugsweise verklebt, da eine Lötung zu einer unerwünschten Erhitzung des Innenbehälters führen könnte. Um einen wirksamen Wärmeaustausch zwischen dem Kältemittelrohr und der Metallschicht durch den Klebstoff hindurch zu gewährleisten, kann dieser mit gut wärmeleitenden mineralischen oder insbesondere metallischen Zusätzen beaufschlagt sein.

Weitere Merkmale der Erfindung ergeben sich aus der nachfolgenden Beschreibung von Ausführungsbeispielen unter Bezugnahme auf die beigefügten Figuren. Diese Beschreibung nennt auch Merkmale der Ausführungsbeispiele, die nicht in den Ansprüchen enthalten sind. Solche Merkmale können auch in anderen als den hier spezifisch offenbarten Kombinationen auftreten. Die Tatsache, dass mehrere solche Merkmale in einem gleichen Satz oder in einer anderer Art von Zusammenhang miteinander erwähnt sind, rechtfertigt daher nicht den Schluss, dass sie nur in der spezifisch offenbarten Kombination auftreten könnten; stattdessen ist grundsätzlich davon auszugehen, dass von mehreren solchen Merkmalen auch einzelne weggelassen oder abgewandelt werden können, sofern dies die Funktionsfähigkeit der Erfindung nicht in Frage stellt. Es zeigen:
- Fig. 1: eine Anfangsphase der Erzeugung einer Metallschicht an einem Kältegeräte-Innenbehälter;
- Fig. 2: ein fortgeschrittenes Stadium der Erzeugung der Metallschicht;
- Fig. 3: die Anbringung einer Kältemittelleitung auf der Metallschicht;
- Fig. 4: den Innenbehälter mit fertigem Verdampfer daran; und
- Fig. 5: eine Ansicht eines Innenbehälters mit Metallschicht gemäß einer vorteilhaften Anwendung der Erfindung.

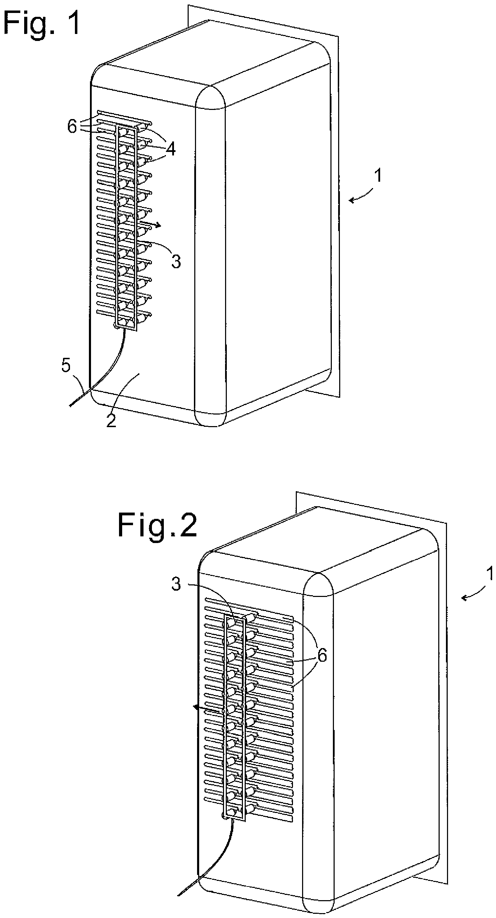

Fig. 1 zeigt in einer perspektivischen Ansicht einen Innenbehälter 1 für ein Haushaltskältegerät. Der Innenbehälter 1 ist in fachüblicher Weise durch Tiefziehen einer Platte aus thermoplastischem Kunststoff, insbesondere Polystyrol, erhalten. Vor der dem Betrachter zugewandten Rückwand 2 des Innenbehälters 1 ist ein Gestell 3 mit einer Vielzahl von daran befestigten Plasmadüsen 4 zu sehen. Die Plasmadüsen 4 können zum Beispiel vom aus DE102 23 865 A1 bekanntem Typ sein. Ein Versorgungsleitungsbündel 5 speist die Plasmadüsen 4 mit elektrischer Energie, mit Prozessgas und, zum Beispiel in im Prozessgas fluidisierter Form, mit Metall-, vorzugsweise Aluminiumpulver. Um eine Oxidation des Aluminiumpulvers in den Plasmadüsen 4 bzw. auf dem Weg von den Plasmadüsen 4 zu der Rückwand 2 zu vermeiden, wird als Prozessgas ein inertes Gas, insbesondere ein Edelgas, verwendet.

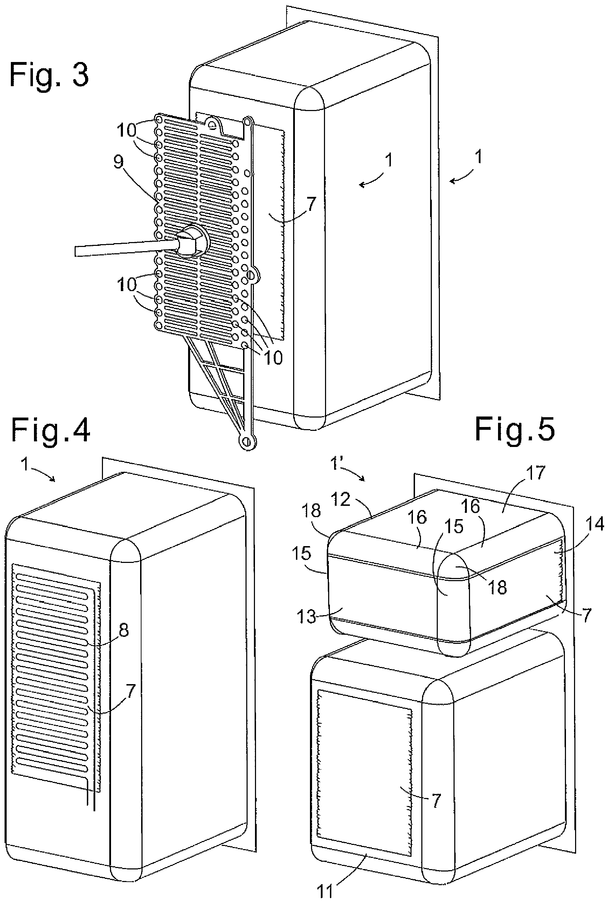

Während das Gestell 3 von links nach rechts über die Rückwand 2 verfahren wird, erzeugt jede Plasmadüse 4 auf der Rückwand 2 einen Aluminiumstreifen 6. In der Ausgestaltung der Fig. 1, mit in zwei Reihen vertikal gegeneinander versetzt angeordneten Plasmadüsen 4, sind die einzelnen Streifen 6 vertikal voneinander beabstandet. Daher muss das Gestell 3 mehrere Male auf der Rückwand 2 hin und her bewegt werden, wie in Fig. 2 zu erkennen, damit die Streifen 6 zu einer einzigen zusammenhängenden Schicht 7 (siehe Fig. 3) zusammenwachsen. Die so erhaltene Schicht 7 haftet eng und fest an der Rückwand 2 und ist frei von Luftblasen oder anderen Kontaktfehlern. Ihre Stärke beträgt z.B. 50 µm.

Es liegt auf der Hand, dass die Zahl der Plasmadüsen 4 oder der Reihen, in denen sie angeordnet sind, erhöht werden kann, um die Zahl der Durchgänge des Gestells 3 über die Rückwand 2, die erforderlich sind, um eine zusammenhängende Schicht 7 zu erhalten, zu reduzieren. So kann die zum Erzeugen der Schicht 7 benötigte Zeit in weitem Umfang variiert und an den Prozesstakt einer laufenden Fertigung angepasst werden.

Zur Anbringung des Kältemittelrohrs an der Schicht 7 kann ein Werkstückträger 9 vom aus DE 10 2009 003 264 A1 bekannten Typ verwendet werden. Dieser umfasst auf einer Trägerplatte eine Vielzahl von flach zylindrischen Biegebolzen, um die das Kältemittelrohr 8 herumgeschlungen wird und an denen es in der Gestalt, in der es hinterher auf der Schicht 7 angebracht wird, fixierbar ist. In der Ansicht der Fig. 4 sind Führungen 10 der Biegebolzen an der Rückseite des Werkstückträgers 9 zu sehen, die Biegebolzen selbst befinden sich auf der der Rückwand 2 zugewandten Vorderseite des Werkstückträgers 9.

Das Kältemittelrohr 8 wird, während es am Werkstückträger 9 verlegt wird, an seiner vom Werkstückträger 9 abgewandten Seite mit Klebstoff beschichtet. Der Werkstückträger mit dem daran gehaltenen fertig geformten Kältemittelrohr 8 wird gegen die Schicht 7 gedrückt. Indem dabei die Biegebolzen in den Werkstückträger 9 hinein verdrängt werden, wird das Kältemittelrohr 8 freigegeben und haftet wie in Fig. 4 gezeigt an der Schicht 7. Jeder in Fig. 4 sichtbaren Biegung des Kältemittelrohrs 8 entspricht ein Biegebolzen des Werkstückträgers 9, an dem sie geformt wurde.
Da die Schicht 7 bei dem erfindungsgemäßen Verfahren nicht vorgefertigt und auf dem Innenbehälter 1 angebracht wird, sondern auf diesem erst entsteht, kann sich die Schicht 7 ohne die Gefahr von Faltenbildung oder dergleichen beliebigen Krümmungen des Innenbehälters 1 anpassen. Das Verfahren eignet sich daher besonders gut, um beispielweise bei einem Innenbehälter 1' eines Kombinationskältegeräts, wie in Fig. 5 gezeigt, an der Rückwand eines Normalkühlfachs 11 einen üblichen planaren Verdampfer auszubilden, während sich beim Gefrierfach 12 die Schicht 7 über Rückwand 13 und Seitenwände 14 erstrecken kann und auch entlang abgerundeter Kanten 15 zwischen der Rückwand 13 und den Seitenwänden 14 mit dem Innenbehälter 1' vollflächig in innigem Kontakt steht. Grundsätzlich bereitet es mit dem erfindungsgemäßen Verfahren keinerlei Schwierigkeiten, die Schicht 7 auch auf abgerundete Kanten 16 rings um die Decke 17 des Gefrierfachs 12 oder gar auf die Decke 17 selber auszudehnen; selbst sphärische Ecken 18, an denen die abgerundeten Kanten 15, 16 aufeinander treffen, können lückenlos beschichtet werden.

## Patentansprüche

1. Verfahren zur Herstellung eines Verdampfers für ein Kältegerät, insbesondere ein Haushaltskältegerät, mit den Schritten:
- Abscheiden einer Metallschicht (7) auf einer Oberfläche (2; 13, 14, 15) eines Innenbehälters (1; 1') aus einem Plasma bei Atmosphärendruck,
- Anbringen eines Kältemittelrohrs (8) in wärmeleitendem Kontakt mit der Metallschicht (7).

2. Verfahren nach Anspruch 1, **dadurch gekennzeichnet, dass** das Plasma in einem sauerstofffreien Trägergas erzeugt wird.

3. Verfahren nach Anspruch 1, **dadurch gekennzeichnet, dass** das Trägergas mit einer Temperatur von unter 200°C auf die Oberfläche trifft.

4. Verfahren nach einem der vorhergehenden Ansprüche, **dadurch gekennzeichnet, dass** die Metallschicht (7) Aluminium ist.

5. Verfahren nach einem der vorhergehenden Ansprüche, **dadurch gekennzeichnet, dass** die Metallschicht (7) unmittelbar auf der Oberfläche (2; 13, 14, 15) des Innenbehälters (1; 1') abgeschieden wird.

6. Verfahren nach einem der vorhergehenden Ansprüche, **dadurch gekennzeichnet, dass** die Dicke der Metallschicht (7) kleiner als 100 µm ist.

7. Verfahren nach einem der vorhergehenden Ansprüche, **dadurch gekennzeichnet, dass** die Dicke der Metallschicht (7) größer als 10 µm ist.

8. Verfahren nach einem der vorhergehenden Ansprüche, **dadurch gekennzeichnet, dass** das Kältemittelrohr (8) auf der Metallschicht (7) verklebt ist.

9. Kältegerät, insbesondere Haushaltskältegerät, mit einem an einem Innenbehälter (1) befestigten Verdampfer, **dadurch gekennzeichnet, dass** eine Platine des Verdampfers eine auf dem Innenbehälter (1) bei Atmosphärendruck abgeschiedene Metallschicht (7) umfasst.

10. Kältegerät nach Anspruch 9, **dadurch gekennzeichnet, dass** die Metallschicht (7) in unmittelbarem Kontakt mit dem Innenbehälter (2) ist.
